# EUROPEAN PATENT APPLICATION

(11) **EP 0 802 563 A2**
(43) Date of publication of application: **22.10.1997**
(21) Application number: 97106310.2
(22) Date of filing: 16.04.1997
(51) Int. Cl.: H01L 21/285

(54) **Method of manufacturing a semi-conductor device having a low resistance metal silicide layer**

(30) Priority: 19.04.1996 JP 97900/96
(71) Applicant: NEC CORPORATION, Tokyo (JP)
(72) Inventor: Ando, Koichi, Minato-ku, Tokyo (JP); Matsubara, Yoshihisa, Minato-ku, Tokyo (JP); Ishigami, Takashi, Minato-ku, Tokyo (JP); Nishimoto, Shozo, Minato-ku, Tokyo (JP); Horiuchi, Tadahiko, Minato-ku, Tokyo (JP)
(74) Representative: Glawe, Delfs, Moll & Partner

(57) **Abstract**

A method of manufacturing a semiconductor comprises a first heat treatment in a hydrogen atmosphere and a second heat treatment in a nitrogen atmosphere whose temperature is higher than that of the first heat temperature after a refractory metal film is formed on a semiconductor substrate. Since the silicification reaction of the refractory metal is promoted by the effect of hydrogen and the nitriding reaction of the refractory metal containing hydrogen is suppressed, the silicification reaction is promoted and the film thickness of a silicide layer becomes large, thereby making it possible to reduce the resistance of wiring having a fine pattern and increase circuit operation speed.

## Description

### Background of the Invention

### 1. Field of the Invention

The present invention relates to a method of manufacturing a semiconductor device and, more specifically, to a method of forming a refractory metal silicide film in a self-aligned manner on a diffusion layer or gate electrode of a MOS transistor.

### 2.Description of Related Art

Attempts to reduce the design rule and to increase the density of semiconductor elements are being continued with vigor. Very large-scale integrated semiconductor devices such as memory devices and logic devices which are designed under the 0.15 to 0.25 µm rule are now being developed and tested. Along with an increase in the integration of such semiconductor devices, especially, reductions in the width of a gate electrode and the width of a diffusion layer as well as the thickness of a material forming semiconductor elements are becoming significant. Among these, reductions in the width of a gate electrode or the wiring width of the gate electrode and the film thickness of a gate electrode material inevitably lead to an increase in the resistance of wiring thereof with the result of a decrease in circuit operation speed. To cope with this problem, in fine patterned semiconductor elements, great importance is attached to a reduction in the resistance of a refractory metal silicide used in part of a gate electrode as an essential technique. Particularly, a self-aligned silicide (salicide) technique which uses titanium metal as a refractory metal is becoming indispensable for a fine structure insulating gate field effect transistor (to be referred to as "MOS transistor" hereinafter).

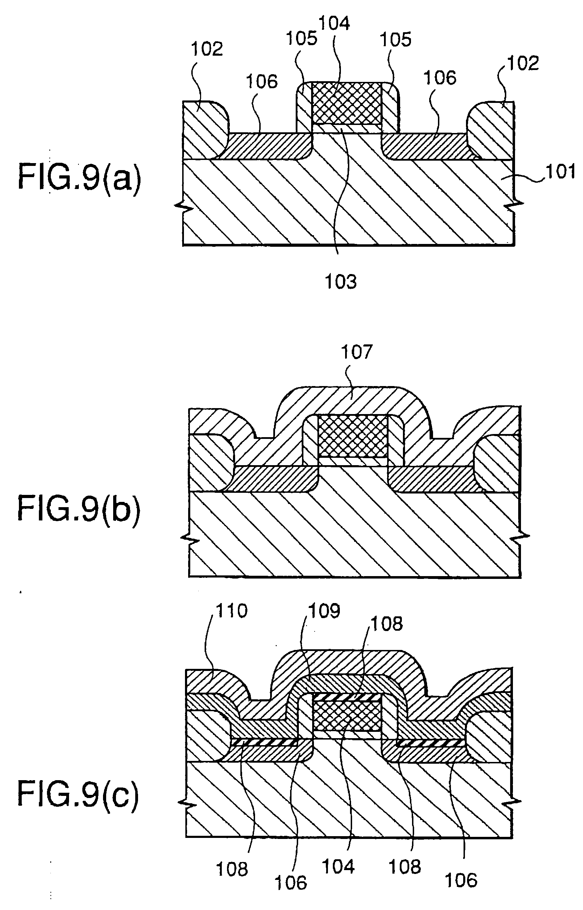

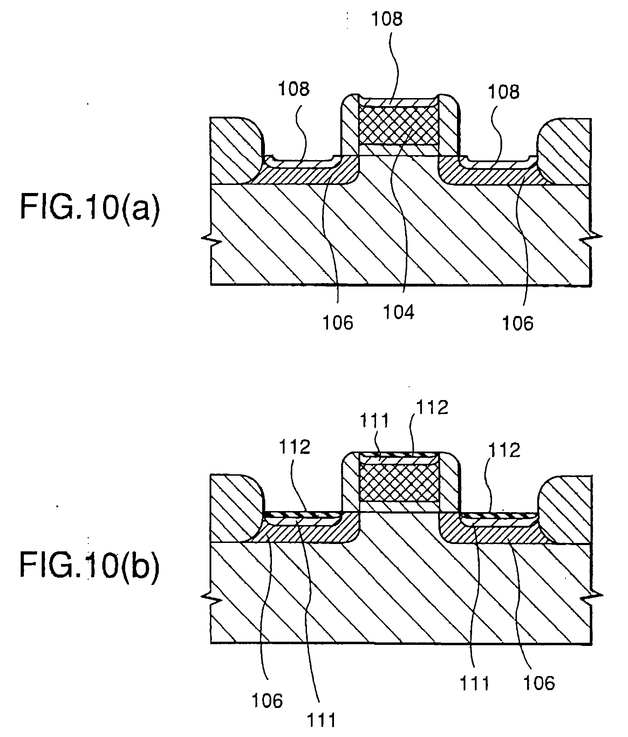

A conventional method of manufacturing a MOS transistor having a self-aligned silicide structure is described with reference to Figs. 9A to 9C and Figs. 10A and 10B. Figs. 9A to 9C and Figs. 10A and 10B are sectional views of a MOS transistor showing the method of forming a self-aligned silicide. As shown in Fig. 9A, an element-separating insulating film 102 is formed in a predetermined region on a silicon substrate 101 by the well known LOCOS process. Thereafter, impurity ions are implanted as a channel stopper, and a gate insulating film 103 is formed by thermal oxidation. An about 150 nm-thick polysilicon film is then formed over the entire surface by CVD (chemical vapor deposition) and an impurity such as phosphorus is doped in the polysilicon film. Thereafter, this polysilicon film is patterned to a desired shape by photolithography and dry etching to form a gate electrode 104. A silicon oxide film is then formed over the entire surface by CVD and then anisotropic dry etching is carried out to form a spacer 105 on both side surfaces (sidewalls) of the gate electrode 104.

Thereafter, impurity ions such as arsenic, boron or the like are implanted to form a diffusion layer 106 by heating at 800 to 1,000°C. When the MOS transistor is of an N-channel type, a diffusion layer including arsenic is formed and when the MOS transistor is of a P-channel type, a diffusion layer including boron is formed. Thus, the diffusion layer 106 serves as source and drain regions of the transistor.

As shown in Fig. 9B, an about 20 nm-thick titanium film 107 is formed over the entire surface by metal sputtering. A heat treatment is carried out in a nitrogen atmosphere for 30 to 60 sec. A lamp annealing device is generally used as a heat treatment device and treatment temperature is set to 600 to 650°C. Thus, titanium is silicificated.

As shown in Fig. 9C, a crystalline C49-structured silicide layer 108 having a high electrical resistivity, a titanium layer containing nitrogen atoms, i.e., a nitrogen-containing titanium layer 109, and a nitrided titanium layer, i.e., a titanium nitride layer 110 are formed in that order on the exposed surface portion of the gate electrode 104 and the exposed surface portion of the diffusion layer 106. Simultaneously, the nitrogen-containing titanium layer 109 and the titanium nitride layer 110 are formed in that order on the element-separated insulating film 102 which is a silicon oxide film and on the sidewall spacers 105.

As shown in Fig. 10A, the above nitrogen-containing titanium layer 109 and the titanium nitride layer 110 are removed by a chemical solution prepared by a mixture of an ammonium aqueous solution, purified water and a hydrogen peroxide solution. The nitrogen-containing titanium film is dissolved in this chemical solution but the titanium nitride layer does not. However, the titanium nitride layer 110 is removed by lift-off caused by the dissolution of the nitrogen-containing titanium layer 109. By the above process, the C49-structured silicide layer 108 is formed in a self-aligned manner only on the gate electrode 104 and the diffusion layer 106 for ource and drain regions.

Thereafter, a second heat treatment is carried out in a nitrogen atmosphere for 60 seconds as the case may be. In this respect, the heat treating device is the above-described lamp annealing device and the treatment temperature is set to 850°C. By this heat treatment, as shown in Fig. 10B, the above C49-structured silicide layer is converted into a different phase, i.e., the C54-structured silicide layer 111 having a low electrical resistivity. Thereafter, a C54-structured silicide layer containing nitrogen atoms, i.e., a nitrogen-containing silicide layer 112 is formed. Through such a series of steps, a refractory metal silicide film is formed in a self-aligned manner over the diffusion layer and gate electrode of the MOS transistor.

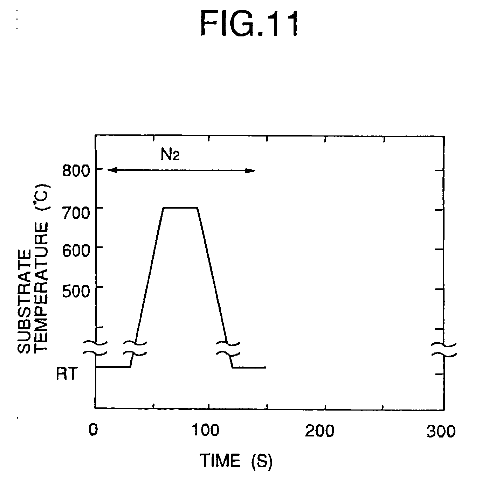

Among the above series of steps, especially, a heat treatment step which is carried out immediately after the titanium film is formed by sputtering is described with reference to Fig. 11. Fig. 11 shows the temperature-time profile of the heat treatment step which is carried out by the conventional method. Firstly, as shown in Fig. 9B, the semiconductor substrate in which the titanium layer is formed over semiconductor elements is inserted into a treatment chamber of the lamp annealing device and the atmosphere of the chamber is fully substituted with a nitrogen gas. Thereafter, the semiconductor substrate is heated to a predetermined temperature, 700°C in this case, by infrared lamp heating and maintained at that temperature for a predetermined time, 30 sec. in this case. The temperature of the semiconductor substrate is lowered by stopping the lamp heating. After the temperature of the substrate is cooled down sufficiently, the semiconductor substrate is taken out from the lamp annealing device to complete the heat treatment step. By this heat treatment step, as shown in Fig. 9C, the crystalline C49-structured silicide layer 108 having a high electrical resistivity, the nitrogen-containing titanium layer 109 and the titanium nitride layer 110 are formed on the exposed surface portion of the gate electrode 104 and the exposed surface of the diffusion layer 106 of the semiconductor substrate. In contrast, the nitrogen-containing titanium layer 109 and the titanium nitride layer 110 are formed on the element-separated insulating film 102 and the sidewall spacers 105.

The above silicide formation technology of the conventional method involves the following problem when the line width of a gate electrode decreases along with a reduction in the design rule of semiconductor elements. That is, it is difficult to form a titanium silicide layer with a gate electrode line width of 0. 3 µm or less, whereby the resistance of electrode wiring increases. This is because most part of the titanium film is changed into titanium nitride and a titanium silicide layer is rarely formed because the silicification reaction rate in a thin line is slow ("thin line effect")and becomes slower than the nitriding reaction in the above conventional scheme of lamp annealing.

The reason for the above problem to arise will be discussed in more detail, hereinafter. When forming a silicide layer, the silicide layer must be selectively formed on the gate electrode and the diffusion layer only. In the formation of the silicide layer, the silicification reaction proceeds with silicon atoms being diffused into a layer of a refractory metal such as titanium. Therefore, a silicide layer is formed even on the spacers which are silicon oxide films and the element-separated insulating film when silicon atoms originating in the diffusion layer or the polysilicon film are diffused into the refactory metal over the spacers or the element-separated insulating film (to be referred to as "overgrowth" hereinafter), thereby making impossible a selective formation of a silicide layer. To prevent this overgrowth, it is necessary to reduce the heat treatment temperature. At such a reduced temperature, the rate of the titanium nitriding reaction is much higher than the rate of the silicification reaction which is impeded by the "thin line effect".

Because of the reason explained above, the conventional method has such a problem that only a titanium nitride layer is formed on the gate electrode and the diffusion layer, and a silicide layer is rarely formed thereon.

### Summary of the Invention

The present invention has been made to solve the above problem, and it is an object of the invention to facilitate the silicification of semiconductor elements of a MOS transistor having a fine pattern and to promote increases in the integration, density and speed of a semiconductor device.

According to the present invention, there is provided a method of manufacturing a semiconductor device comprising the steps of forming a thin film of a refractory metal on a semiconductor substrate having a region from which a semiconductor layer is exposed and forming a refractory metal silicide layer on the contact surface between the refractory metal and the semiconductor layer by heating the semiconductor substrate, characterized in that the heat treatment step comprises a first heat treatment which is carried out in an atmosphere containing hydrogen atoms and a second heat treatment which is carried out in an atmosphere containing nitrogen atoms. According to the present invention, the first and second heat treatments may be carried out continuously in the same heating device and the heating temperature of the first heat treatment is preferably lower than the heating temperature of the second heat treatment. Further, the first heat treatment may be for heating in an atmosphere containing hydrogen atoms and the second heat treatment may be for heating and maintaining in an atmosphere containing nitrogen atoms. Still further, the first heat treatment and the second heat treatment may be carried out in an atmosphere containing both hydrogen atoms and nitrogen atoms.

Further yet, according to the present invention, a heat treatment step is carried out in an atmosphere containing nitrogen atoms, using a hydrogen-containing refractory metal or a hydrogenated refractory metal as the refractory metal. In the present invention, the refractory metal is preferably titanium, but other refractive metals may be used.

### Brief Description of the Drawings

The above and other objects, advantages and features of the present invention will be more apparent from the following description taken in conjunction with the accompanying drawings in which:
Figs. 1A to 1C are sectional views 1 showing an embodiment of a manufacturing method of the present invention in the order of manufacturing steps;
Figs. 2A to 2C are sectional views 2 showing an embodiment of a manufacturing method of the present invention in the order of manufacturing steps;
Fig. 3 is a time-temperature profile diagram of a heating step in the present invention;
Fig. 4 is a graph showing a nitriding reaction suppression phenomenon in the present invention;
Fig. 5 is a graph showing an effect of reduction in the resistance of the silicide layer by the present invention;
Fig. 6 is a time-temperature profile diagram of a heating step in another method of the present invention;
Fig. 7 is a time-temperature profile diagram of a heating step in still another method of the present invention;
Fig. 8 is a time-temperature profile diagram of a heating step in a further method of the present invention;
Fig. 9 is a sectional view 1 showing an example of the manufacturing method of the prior art in the order of manufacturing steps;
Fig. 10 is a sectional view 2 showing an example of the manufacturing method of the conventional method in the order of manufacturing steps; and
Fig. 11 is a time-temperature profile diagram of a heating step in the conventional method.

### Detailed Description of the Preferred Embodiment

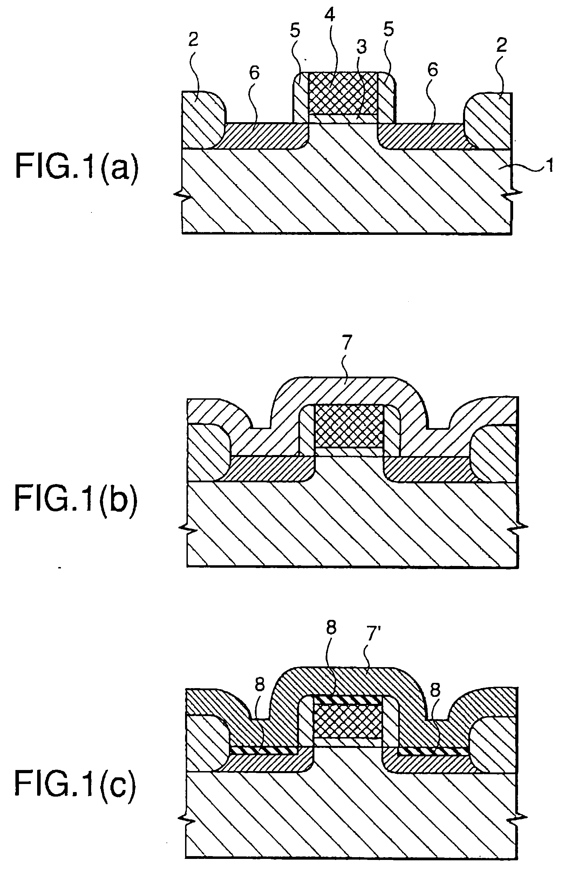

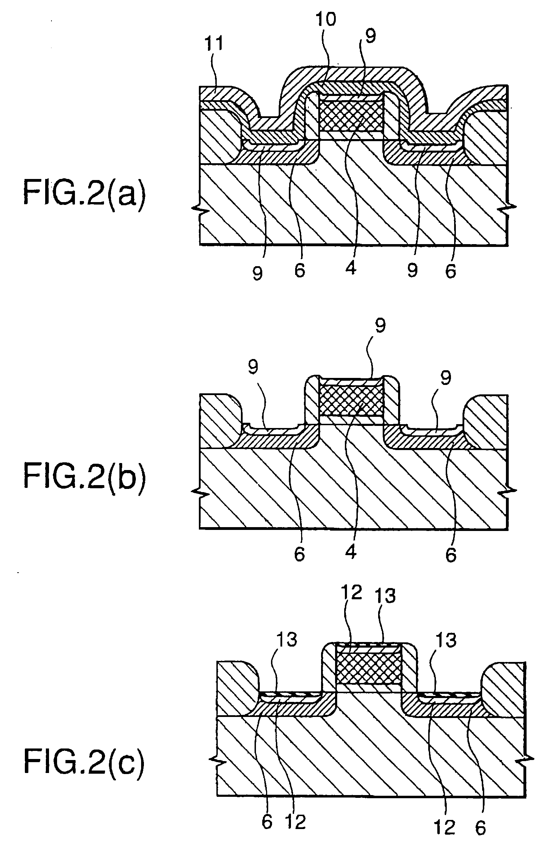

A preferred embodiment of the present invention is described with reference to the accompanying drawings. Figs. 1A to 1C and Figs. 2A to 2C are sectional views showing a self-aligned silicide forming method of the present invention in the order of manufacturing steps. For the formation of a MOS transistor, almost the same steps up to the step of forming a titanium film by sputtering as in the conventional method are carried out. In other words, as shown in Fig. 1A, a 300 nm-thick element-separating insulating film 2 is formed in a predetermined region on a P-conductive or P-well formed silicon substrate 1 by the known LOCOS process. Thereafter, boron impurity ions for the channel stopper are implanted and then, an about 8 nm-thick insulating film 3 is formed by thermal oxidation. An about 150 nm-thick polysilicon film is then formed over the entire surface by CVD (chemical vapor deposition) and an impurity such as phosphorus is doped. Subsequently, the polysilicon film is patterned to a desired shape by photolithography and dry etching to form a gate electrode 4. A silicon oxide film is formed over the entire surface by CVD and then anisotropic dry etching is carried out to form a sidewall spacer 5 on both side surfaces of the gate electrode 4. Further, impurity ions such as arsenic, boron or the like are implanted to form the diffusion layer 106 by heating at 800 to 1,000°C. When the MOS transistor is of an N-channel type, a diffusion layer including arsenic is formed and when the MOS transistor is of a P-channel type, a diffusion layer including boron is formed. The diffusion layer serves as source and drain regions of a transistor.

As shown in Fig. 1B, an about 20 nm-thick titanium layer 8 is then formed over the entire surface by metal sputtering. Subsequently, a first heat treatment is carried out in an atmosphere of a hydrogen gas for 30 seconds. This first heat treatment is carried out in a lamp annealing device and the temperature thereof is set to 550°C, for example. By this heat treatment, as shown in Fig. 1C, the titanium film 7 is converted into a titanium layer containing hydrogen atoms, i.e., a hydrogen-containing titanium film 7'. At this point, a 10 to 20 nm-thick amorphous titanium silicide layer 8 (TiSix: x <2) is formed only on the surface where the gate electrode 4 is exposed and the surface of the diffusion layer 6. However, since the heating temperature is sufficiently low, the silicide layer does not overgrow on the sidewall spacers or the element-separating insulating film 2.

Thereafter, a second heat treatment is carried out in a nitrogen atmosphere for 30 seconds. This second heat treatment is carried out in the lamp annealing device and the temperature thereof is set to about 700°C. Owing to this series of heat treatments, as shown in Fig. 2A, a crystalline C49-structured silicide layer 9 having a high electrical resistivity, a titanium layer having nitrogen atoms, i.e., nitrogen-containing titanium layer 10 and a titanium nitride layer 11 are formed on the surface at which the gate electrode 4 is exposed and the surface of the diffusion layer 6. In contrast, the above nitrogen-containing titanium layer 10 and the titanium nitride layer 11 are formed on the element-separating insulating film 2 and the sidewall spacers 5.

The film thickness of the above C49-structured silicide layer 9 formed on the surface at which the gate electrode 4 is exposed and the surface of the diffusion layer 6 is larger than the film thickness of a silicide layer formed from a titanium layer having the same thickness by the prior art. This is because, only the silicification reaction which is in a trade-off relationship with the nitriding reaction is initiated in the first heat treatment in the hydrogen atmosphere. And in the subsequent second heat treatment in a nitrogen atmosphere the silicification reaction is promoted since the rate of the nitridation reaction of hydrogen-containing titanium is lower than that of titanium containing no hydrogen as will be described later.

Thereafter, as shown in Fig. 2B, the nitrogen-containing titanium layer 10 and the titanium nitride layer 11 are removed by a chemical solution prepared by mixing an ammonia aqueous solution, purified water and a hydrogen peroxide solution. The nitrogen-containing titanium film is dissolved in the chemical solution but the titanium nitride layer does not. However, the titanium nitride film 11 is removed by lift-off caused by the dissolution of the underlying nitrogen-containing titanium layer 10. In this instance, a chemical solution prepared by mixing sulfuric acid, purified water and a hydrogen peroxide solution may be used in place of the above chemical solution. By the above step, the C49-structured silicide layer 9 is formed in a self-aligned manner only on the diffusion layer 6 for forming source and drain regions and the gate electrode 4.

A heat treatment is then carried out in a nitrogen atmosphere for 60 seconds. The above lamp annealing device is used as the heat treatment device and the treatment temperature is set to 850°C, for example. By this treatment, as shown in Fig. 2C, the above C49-structured silicide layer 9 is converted into a C54-structured silicide layer 12 having a low electrical resistivity. Thus, a MOS transistor having a silicide layer selectively formed on the surface of the gate electrode 4 and the surface of the diffusion layer 6 is formed. And the electrical resistances of the gate electrode and the source drain regions are reduced.

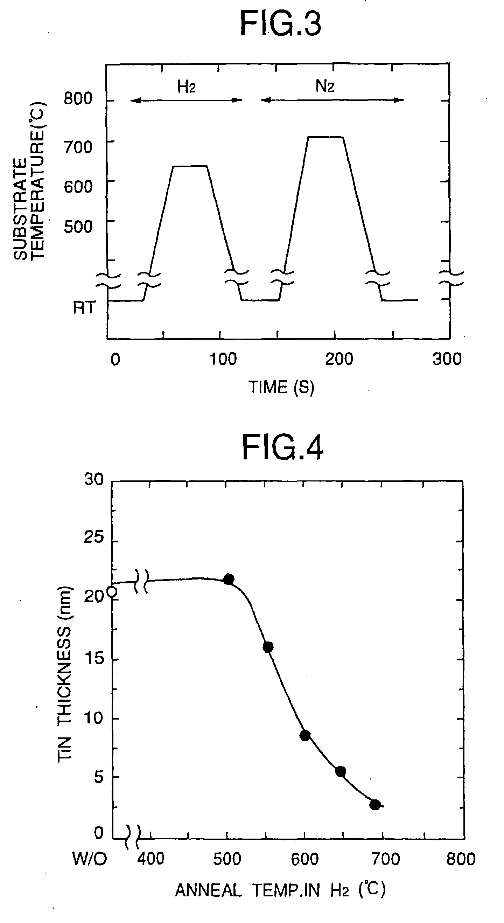

Out of the series of the steps of the above embodiment, the step for carrying out continuously the first heat treatment in an atmosphere containing hydrogen atoms and the second heat treatment in an atmosphere containing nitrogen atoms, which are performed after the formation of a titanium film over the entire surface of the semiconductor substrate is described in further detail with reference to Fig. 3.

Fig. 3 shows the temperature-time profile of the heat treatment step to be carried out by the present invention. Firstly, the semiconductor substrate in which the titanium layer is formed over the entire surface of semiconductor elements shown in Fig. 1B is inserted into the treatment chamber of the lamp annealing device, the atmosphere of the treatment chamber is fully substituted with a hydrogen gas, and lamp heating is carried out at a semiconductor substrate temperature of about 550°C for 30 seconds as the first heat treatment. Thereafter, heating is temporarily stopped, the atmosphere is substituted with a nitrogen gas, and lamp heating is carried out at a semiconductor substrate temperature of about 700°C for 30 seconds as the second heat treatment. In this case, the first heat treatment and the second heat treatment are carried out continuously without taking out the semiconductor substrate from the treatment chamber of the lamp annealing device between the first heat treatment and the second heat treatment. After the semiconductor substrate temperature is substantially lowered, the semiconductor substrate is taken out from the lamp annealing device to complete a series of heat treatment steps.

By the first heat treatment out of this series of heat treatment steps, as having been explained with reference to Fig. 1C, the titanium film 7 is converted into a titanium layer containing hydrogen atoms, i.e., an amorphous titanium silicide layer 8 and a hydrogen-containing titanium film 7' on the ouuter surface is formed on the surface at which the gate electrode 4 is exposed and the surface of the diffusion layer 6. By the second heat treatment, as having been explained with reference to Fig. 2C, a crystalline C49-structured silicide layer 9 having a high electrical resistivity, a titanium layer containing nitrogen atoms, i.e., nitrogen-containing titanium layer 10 and a titanium nitride layer 11 are formed on the surface at which the gate electrode 4 is exposed and the surface of the diffusion layer 6. In contrast, the above nitrogen-containing titanium layer 10 and the titanium nitride layer 11 are formed on the element-separating insulating film 2 which is a silicon oxide film and the sidewall spacers 5. The film thickness of the C49-structured silicide layer 9 which is formed on the surface from which the gate electrode 4 is exposed and the surface of the diffusion layer 6 is larger than the film thickness of a silicide layer formed from a titanium film having the same thickness by the conventional method.

While the case where the temperature of the first heat treatment which is carried out in a hydrogen atmosphere is lower than the temperature of the second heat treatment which is carried out in a nitrogen atmosphere has been described above, the temperature of the first heat treatment may be higher than the temperature of the second heat treatment if the amorphous silicide layer, which of course is not limited to amorphous state, formed by the first heat treatment does not overgrow and the C49-structured silicide layer is formed by the second heat treatment. For instance, the first heat treatment may be carried out at 670°C for 1 second and the second heat treatment may be carried out at 650°C for 100 seconds. However, as having being explained in this embodiment, when the temperature of the first heat treatment is set to a temperature lower than the temperature of the second heat treatment, the risk of overgrowth caused by variations in processing conditions (instability of production conditions) reduces and the throughput per unit time can be increased at the same time.

A detailed description is next given of the reasons why the C49-structured silicide layer 9 formed by the present invention is thicker than a silicide layer formed by the conventional technology, namely, why the formation of a silicide layer is promoted. The first reason is that a silicification reaction itself is promoted. A silicification reaction proceeds by the first heat treatment in a hydrogen atmosphere without causing a nitriding reaction. It was found that this silicification reaction is promoted by the effect of hydrogen. Although the amorphous titanium silicide layer 8 formed by this silicification reaction is neither C49-structured nor C54-structured silicide layer (both having a composition of TiSi2) and cannot function as a low-resistance wiring material by itself, it is easily changed into a C49-structured silicide layer. Further, the formation of the C49-structured silicide layer which proceeds by the diffusion of silicon atoms into the hydrogen-containing titanium layer is promoted by the subsequent second heat treatment in a nitrogen atmosphere at the same time.

On the other hand, in the conventional method, the formation of a C49-structured silicide layer is first initiated by a heat treatment in a nitrogen atmosphere. Therefore, when a C49-structured silicide layer is to be formed by a heat treatment in a nitrogen atmosphere at the same temperature in a equal amount of time, a C49-structured silicide layer formed by the present invention is thicker than a C49-structured silicide layer formed by the conventional method.

The second reason is that due to incorporation of hydrogen into the film nitridation reaction is suppressed by the second heat treatment in a nitrogen atmosphere. Fig. 4 shows the dependence of the thickness of the titanium nitride film formed by the second heat treatment in a nitrogen atmosphere on the temperature of the first heat treatment in a hydrogen atmosphere. The nitridiation reaction of the hydrogen-containing titanium layer is suppressed more than in a normal titanium nitridation reaction. It can be seen that the suppression effect is larger as the temperature of the first heat treatment in a hydrogen atmosphere increases. In the heat treatment in a nitrogen atmosphere, a silicification reaction which proceeds with the diffusion of silicon atoms into titanium -this proceeds from the interface between titanium and silicon toward the surface of the film; and a nitriding reaction which proceeds with the diffusion of nitrogen atoms into titanium -this proceeds from the surface of the film in the direction of the substrate; compete with each other and have a trade-off relationship. In other words, the nitriding reaction (the formation of the titanium nitride layer and the nitrogen-containing titanium layer) and the silicification reaction (the formation of the silicide layer) struggle for a limited number of titanium atoms. Since the nitriding reaction is suppressed in the present invention, the silicification reaction which is in competition with the nitriding reaction is promoted.

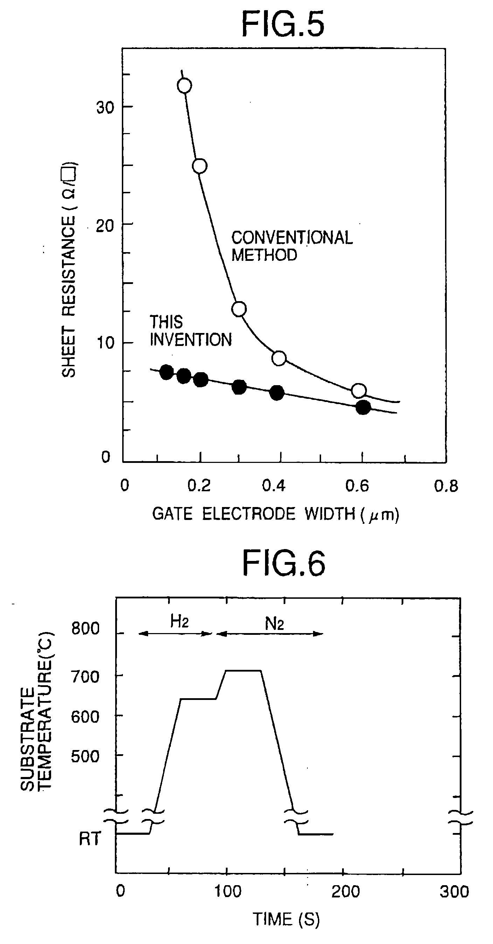

A description is subsequently given of the promotion of a silicide layer and with reference to Fig. 5. Fig. 5 shows the dependence of the resistance of the silicide layer on the line width of the gate electrode. The titanium film which is used for the formation of the silicide layer and formed by sputtering is 20 nm thick. The temperature of the first heat treatment which is carried out in a hydrogen atmosphere is 550°C and other steps are the same as in the above embodiment. In the figure, the resistance value of the silicide layer formed by the conventional method is shown for comparison. As shown in Fig. 5, when the line width of the gate electrode is 0.1 to 0.6 µm, the resistance of the layer is almost uniform at 5 to 8 Ω in the present invention. In contrast to this, when the line width of the gate electrode is 0.3 µm or less, the resistance of the layer sharply increases in the conventional method. Thus, the effect of the present invention becomes more marked as the design rule of semiconductor elements reduces or the integration of a semiconductor device increases.

This effect is marked when the titanium film formed by sputtering is as thin as 30 nm or less, that is, the formation of the titanium nitride layer and the nitrogen-containing titanium layer which proceeds from the surface of titanium reaches the titanium silicide layer before the formation of the titanium silicide layer is completed. It has been described that when the line width of the gate electrode is as small as 0.3 µm or less, the silicification reaction slows down. The effect of the present invention is also marked when the silicification reaction slows down because of the concentration of impurities contained in polycrystal silicon as the gate electrode and the diffusion layer being high.

A second embodiment of the present invention will be explained with reference to Fig. 6. As shown in Fig. 6, the second heat treatment in an atmosphere containing nitrogen atoms may be carried out subsequent to the first heat treatment in an atmosphere containing hydrogen atoms by switching the flow of gas and elevating the temperature after the first heat treatment without stopping heating. Thereby, the throughput per unit time can be made greater than the process in which heating is temporarily stopped in the first embodiment as shown in Fig. 3.

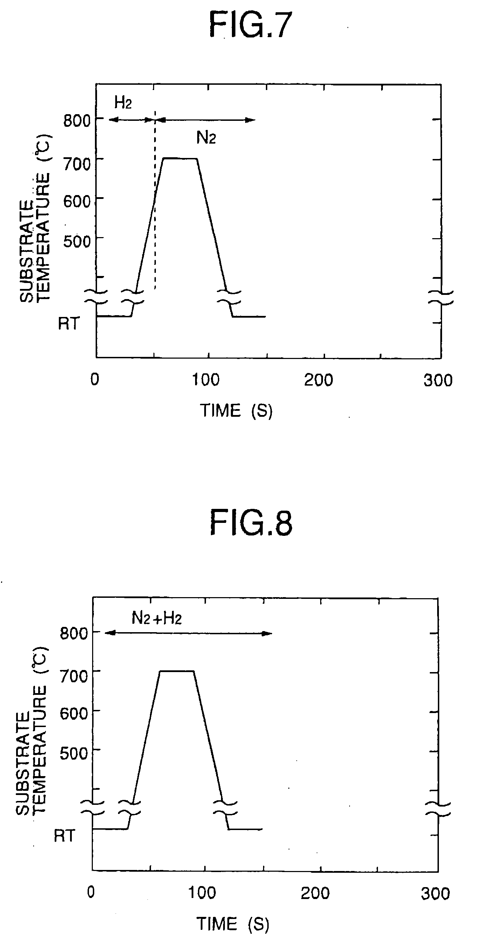

A third embodiment of the present invention will be explained with reference to Fig. 7. As shown in Fig. 7, the temperature of the semiconductor substrate may be increased to a desired temperature, for example, 600°C in an atmosphere containing hydrogen atoms, then to a predetermined temperature, for example, 700°C, in an atmosphere containing nitrogen atoms, maintained at that temperature for a predetermined time, for example, 30 seconds, and then reduced. Thereby, the throughput per unit time can be made greater than the process in which heating is temporarily stopped in the above embodiment as shown in Fig. 3 and the process in which the temperature is elevated stepwise as shown in Fig. 6. One way to accomplish such a temperature-time profile is to place the substrate in a heat treatment chamber and change the gas type from hydrogen to nitrogen while raising the temperature. As another possible way, transfering the substrate from a hydrogen filled chamber to a nitrogen filled chamber, wherein both chambers have a predetermined temperature profile to meet the necessary process conditions should also be possible.

A fourth embodiment of the present invention will be explained with reference to Fig. 8. As shown in Fig. 8, the semiconductor substrate may be heated at a desired temperature for a desired time, for example, at 700°C for 30 seconds in an atmosphere containing both hydrogen atoms and nitrogen atoms. In this case, the promotion of the silicification reaction and the suppression of the nitriding reaction can be realized as in each of the above embodiments by setting the flow rate of a hydrogen gas to 10 times or more that of a nitrogen gas. Thereby, the throughput per unit time can be increased and the substitution of a gas as in each of the above embodiments is unnecessary at the same time, thereby improving production stability.

In each of the above embodiments, the first heat treatment which is carried out in an atmosphere containing hydrogen atoms and the second heat treatment which is carried out in an atmosphere containing nitrogen atoms are continuously performed after the formation of the titanium film over the entire surface of the semiconductor substrate by metal sputtering. The semiconductor substrate may be taken out from the treatment chamber of the lamp annealing device between the first and second heat treatments and exposed to the air. Obviously, the first heat treatment and the second heat treatment may be carried out in separate lamp annealing devices as a matter of course. However, it is needless to say that the throughput per unit time can be increased by carrying out the first heat treatment and the second heat treatment continuously in the same device.

While the application of the present invention to the formation of a silicide layer of a MOS transistor has been described in each of the above embodiments, the present invention may be applied to the formation of a silicide layer on a polycrystal silicon film which is used as a wiring material between MOS transistors and a diffusion layer in a semiconductor device. The present invention may also be applied to the formation of a silicide layer on the surface of the diffusion layer which is exposed by opening contact holes in an interlayer insulating film to make conductive the diffusion layer on the surface of a substrate with a metal wiring and a metal plug on an interlayer insulating film. However, since the impediment of a silicification reaction caused by a reduction in the line width of the gate electrode of a MOS transistor is now the most serious problem to be solved and the overgrowth of the silicide layer is the most fatal device structure, the application of the present invention to the formation of a silicide layer in a MOS transistor is the most effective.

While titanium has been described as an example of the refractory metal, the present invention can be applied to any refractory metal or high melting point metal such as nickel, tantalum or zirconium if it forms a metal hydride. However, use of titanium is the most effective in reducing the resistivity of the silicide layer.

In summary, as having been described above, since the present invention comprises the first heat treatment step which is carried out in an atmosphere containing hydrogen atoms and the second heat treatment step which is carried out in an atmosphere containing nitrogen atoms for the formation of a refractory metal silicide layer by heating a refractory metal formed on the semiconductor substrate as heat treatment steps, the silicification reaction of the refractory metal is promoted by the effect of hydrogen and the nitriding reaction of the refractory metal containing hydrogen is suppressed. As a result, the silicification reaction is promoted and the formed silicide layer is made thick, thereby making it possible to manufacture a semiconductor device capable of reducing the resistance of wiring and increasing circuit operation speed in spite of a reduction in wiring width. Therefore, it is easy to form a silicide layer on a semiconductor device such as a MOS transistor having a reduced design rule, thereby further promoting an increase in the integration, density and speed of the semiconductor device.

While the present invention has been described in connection with certain preferred embodiments, it is to be understood that the subject matter encompassed by way of the present invention in not to be limited to those specific embodiments. On the contrary, it is intended for the subject matter of the invention to include all alternatives, modifications and equivalents as can be included within the spirit and scope of the following claims.

## Claims

1. A method of manufacturing a semiconductor device said method comprising the steps of:
forming a refractory metal film on a semiconductor substrate having a region at which a silicon containing layer is exposed; and
forming a refractory metal silicide layer at an contact interface between said refractory metal film and said silicon containing layer by a heat treatment of said semiconductor substrate, characterized in that said heat treatment comprises a first heat treatment which is carried out in an atmosphere containing hydrogen atoms and a second heat treatment subsequent to said first heat treatment, said second heat treatment carried out in an atmosphere containing nitrogen atoms.

2. The method of manufacturing a semiconductor device as claimed in claim 1, wherein said first heat treatment and said second heat treatment are carried out continuously in a same heat treatment chamber.

3. The method of manufacturing a semiconductor device as claimed in claim 1, wherein a maximum heating temperature of said first heat treatment is lower than a maximum heating temperature of said second heat treatment.

4. The method of manufacturing a semiconductor device as claimed in claim 1, wherein the temperature of said substrate is continuously increased during said first heat treatment and the temperature of said substrate is maintained at a constant temperature for a certain period of time during said second heat treatment.

5. The method of manufacturing a semiconductor device as claimed in claim 1, wherein said first heat treatment and said second heat treatment are carried out simultaneously in an atmosphere containing both hydrogen atoms and nitrogen atoms.

6. The method of manufacturing a semiconductor device as claimed in claim 5, wherein a flow rate of hydrogen is more than 10 times higher than a flow rate of nitrogen during said first heat treatment and said second heat treatment.

7. A method of manufacturing a semiconductor device said method comprising the steps of:
forming a refractory metal film containing hydrogen on a semiconductor substrate having a region at which a silicon containing layer is exposed; and
forming a refractory metal silicide layer at an contact interface between said refractory metal film and said silicon containing layer by a heat treatment of said semiconductor substrate carried out in an atmosphere containing nitrogen atoms.

8. The method of manufacturing a semiconductor device as claimed in claim 1 wherein said refractory metal is one selected from the group consisting of titanium, nickel, tantalum and zirconium.

9. The method of manufacturing a semiconductor device as claimed in claim 1, wherein said refractory metal is a metal capable of forming a metal hydride.

10. The method of manufacturing a semiconductor device as claimed in claim 7, wherein said refractory metal is one selected from the group consisting of titanium, nickel, tantalum and zirconium.

11. The method of manufacturing a semiconductor device as claimed in claim 7, wherein said refractory metal is a metal capable of forming a metal hydride.

12. A method of manufacturing a semiconductor device said method comprising the steps of:
forming a titanium film on a polysilicon gate region and a impurity diffusion region formed on a semiconductor substrate;
heat treating in a hydrogen atmosphere said semiconductor substrate having said titanium film formed thereon to form an amorphous titanium silicide layer at an contact interface between said titanium film and said polysilicon gate region and said impurity diffusion region, and a hydrogen incorporated titanium layer at the surface of said titanium film;
heat treating said semiconductor substrate having said titanium film with said hydrogen incorporated therein in a nitrogen atmosphere to form a C49 structure titanium silicide layer at an contact interface between said titanium film and said polysilicon gate region and said impurity diffusion region, and a nitrided titanium layer at the surface of said refractory metal film;
removing said nitrided titanium layer; and
heat treating said C49 structure rtitanium silicide layer to selectively form a C54 structure titanium silicide layer on said polysilicon gate region and said impurity diffusion region.
